**Europäisches Patentamt**

**European Patent Office**

**Office européen des brevets**

(19)

(11) Publication number: **0 103 412**
**B1**

# EUROPEAN PATENT SPECIFICATION

(12)

(45) Date of publication of patent specification: **15.04.87**

(51) Int. Cl.⁴: **H 05 K 7/20**

(21) Application number: **83304679.0**

(22) Date of filing: **12.08.83**

(54) Control apparatus for inverters, etc.

(30) Priority: **12.08.82 JP 122710/82 u**
**12.08.82 JP 122712/82 u**

(43) Date of publication of application:
**21.03.84 Bulletin 84/12**

(45) Publication of the grant of the patent:
**15.04.87 Bulletin 87/16**

(84) Designated Contracting States:
**DE FR GB**

(56) References cited:
**DE-U-7 003 178**
**DE-U-8 135 310**
**US-A-3 198 991**
**US-A-3 305 704**
**US-A-4 166 665**

(73) Proprietor: **MITSUBISHI DENKI KABUSHIKI**
**KAISHA**
**2-3, Marunouchi 2-chome Chiyoda-ku**
**Tokyo 100 (JP)**

(72) Inventor: **Ito, Eizi**
**2204-2, Aza Mukayama Higashidanaka**
**Komaki Aichi Prefecture (JP)**

(74) Representative: **Lawson, David Glynne et al**
**MARKS & CLERK 57-60 Lincoln's Inn Fields**
**London WC2A 3LS (GB)**

Courier Press, Leamington Spa, England.

## Description

### Background of the Invention

The present invention relates to a control apparatus for inverters, etc. and more particularly to the construction of a housing thereof.

In general, as electrical circuit element constituting an inverter apparatus there are elements for a main circuit and those for a control circuit, and the heat generated from diodes, thyristers, transister modules, etc. as the elements for the main circuit is relatively large.

In the case of machinery having a large capacity the degree of heat loss can be as high as about 1 kW. Therefore, it is necessary to dissipate the generated heat through fins of aluminum die cast product so as to use the diode, thyristors, transistor elements, etc. in their normal characteristics, and at the same time in an effort so as not to subject electronic elements for the control circuits provided on a printed circuit board to the effects of temperature, lengthening the life of the elements and increasing their reliability.

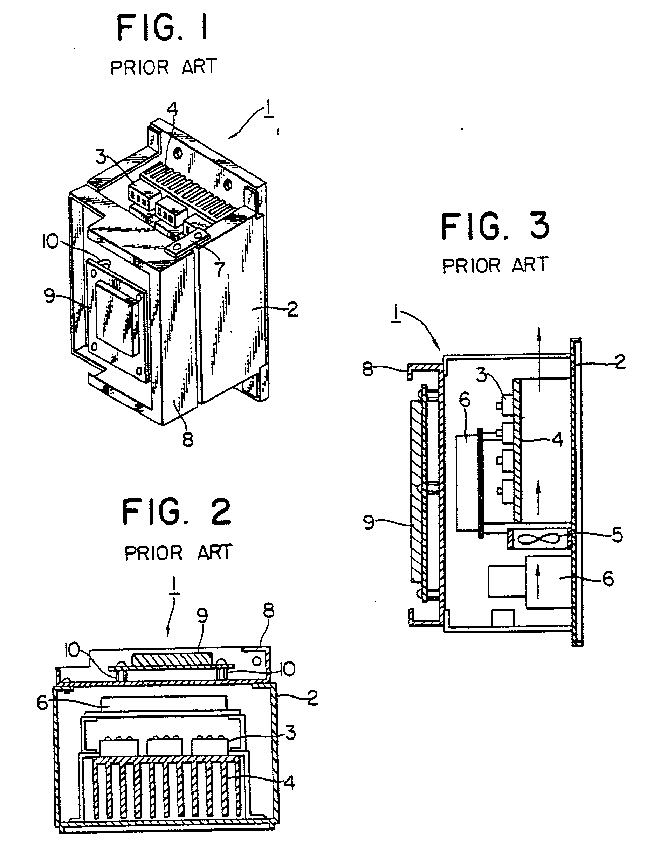

Here, an example of an inverter as a conventional control apparatus of this kind is shown in Figs. 1 to 3 of the attached drawings. In these figures, within the chassis 2 of a control apparatus 1 having generally a rectangular cross-section fins 4 of an aluminum die cast product are secured to which are mounted semiconductor elements for a main circuit, and are adapted to dissipate heat generated from semiconductor elements 3 constituting the main circuit. For this purpose a fan 5 is mounted inside chassis 2 below radiating fins 4 and other elements 6 constituting the circuits are also mounted within chassis 2. On a panel 8 which is hinged to chassis 2 by hinges 7 provided above and below thereof, respectively, at the right-hand side face as viewed in Fig. 1 so as to be opened and closed a printed circuit board 9 is mounted through insulating spacers 10. The constitutional parts above discribed are wired together based on circuit diagrams.

Upon operation of the inverter apparatus, main circuit electrical elements 3 generate heat that is transferred to radiating fins 4 so that their temperature is raised, but, due to the air of fan 5 located therebelow passing through and striking thereto the temperature is lowered and the semiconductor elements for main electrical circuit 3 are adapted to be maintained within a predetermined guarantee temperature range. However, in this case a problem arises in the external dimension of the chassis or housing 2 to contain the apparatus, i.e. the internal volume of the housing. The inner volume of the housing needs to be sufficiently large enough for the heat generated from the invertor apparatus as a whole to dissipate naturally through the outer surface of the housing so that the temperature within the housing is maintained within the guarantee temperatures of the components. However, in this case, since in the conventional apparatus the housing is constituted as stated above, when it is necessary to have the external dimension of the housing made large, it is necessary to fabricate all of the housing components anew. Therefore, this has the disadvantage of making the standardisation of fabrication difficult. Further, since the heated air circulated by fan 5 imparts thermal effects to main circuit components 3 and other elements 6, it results in decrease in their life and reliability.

West German Utility Model Specification G 81 35 310.3 discloses a power electronic control apparatus comprising a chassis which defines a cooling air duct, ventilating means for passing air through the duct, and at least one circuit component mounted on a side wall of the chassis through an opening formed in the side wall. The cooling air duct decreases in width, in the direction of flow. A disadvantage of this construction is that a special duct construction must be provided for each different number of semi-conductor devices to be cooled. Standardised fabrication is therefore not possible.

It is an object of the present invention to provide a control apparatus which has an improved cooling constitution in order to effectively dissipate the heat generated from the electrical circuit components, which is easy to assemble and allows the realisation of standardising its fabrication.

In accordance with the present invention there is provided a power electronic control apparatus comprising a chassis which defines a cooling air duct, ventilating means for passing air through the duct, and at least one circuit component mounted on a side wall of the chassis through an opening formed in the side wall, characterised in that the chassis has its side walls formed of sheet metal, and upper and lower ends consisting of cast frames of standardised dimensions with air-flow apertures, and the ventilating means is mounted in an aperture in at least one of the said cast frames so as to pass cooling air through the air duct formed by the cast end frames and the sheet metal sides, the cast end frames being attached to the sheet metal sides.

The sheet metal chassis preferably has a generally rectangular cross-section tube shape, with die cast hollow end frames having a cross-section similar to that of the chassis.

According to one preferred feature of the present invention the electrical circuit elements are mounted to radiating fins which are secured to the side of the chassis so as to close the opening formed therein.

The present invention control apparatus imparts no thermal effect to other electrical circuit elements because it has a separate passage for the heated air. It can prolong the life of the electrical circuit components and increase their reliability.

These and other objects of the present invention will become more readily apparent upon reading the following specification and upon reference to the accompanying drawings, in which:

Fig. 1 is a perspective view of a conventional inverter apparatus;

Fig. 2 is a cross sectional plan view of the apparatus shown in Fig. 1;

Fig. 3 is a longitudinal side sectional view of the apparatus shown in Fig. 1;

Fig. 4 is a perspective view of one embodiment of the present invention;

Fig. 5 is a cross sectional plan view of the embodiment shown in Fig. 4;

Fig. 6 is a partial longitudinal sectional view of the embodiment shown in Fig. 4 on a larger scale;

Fig. 7 is an exploded perspective view of the embodiment shown in Fig. 4; and

Figs. 8 and 9 are partial perspective views of other embodiments of the present invention, respectively.

Description of the Preferred Embodiments

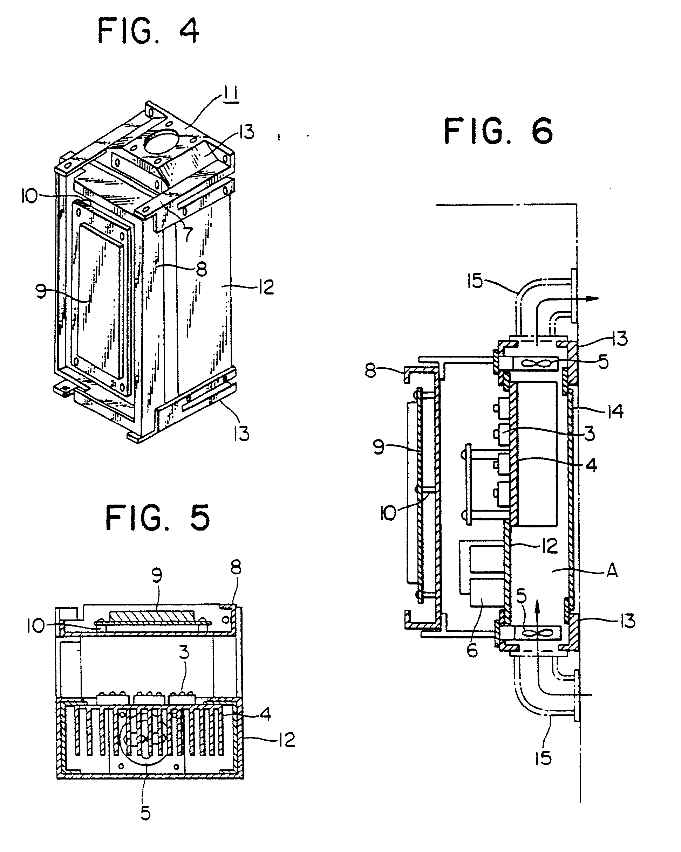

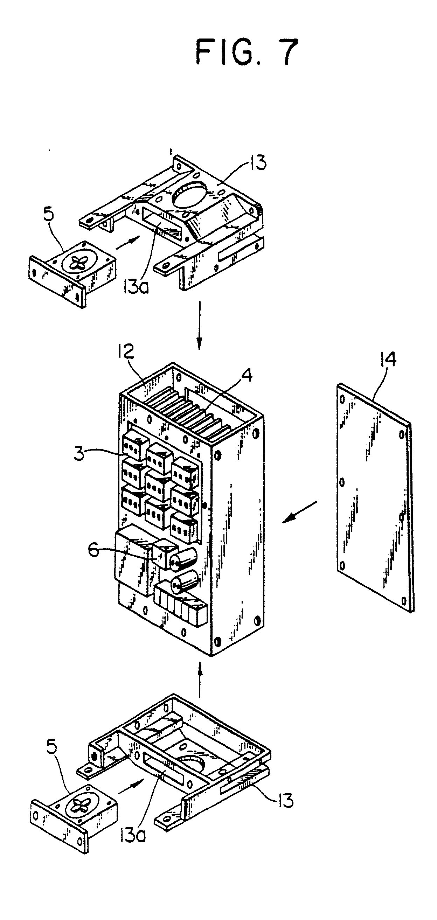

Referring now to Figs. 4 to 7 of the attached drawings wherein is shown an embodiment of the present invention, a hollow chassis 12 of a control apparatus 11 has fins 4 secured thereto inside thereof to cause heat generated from the electrical elements 3 from the main circuit (hereinafter referred to as "semiconductor elements"), comprised of semiconductor elements to be dissipated, fins 4 being of a die cast product of aluminum and semiconductor elements 3 being mounted thereto.

In this case, chassis 12 has a rectangular cross-section and is provided with a rectangular opening in one of its side surfaces the size of which is somewhat larger than the external dimensions of semiconductor elements 3, whereby it is taken into consideration that radiating fins 4 are to be mounted to the rear surface of one of the sides of chassis 12 and are not to project past the front surface thereof. Chassis 12 has thus a rectangular cross-section and cast frames 13 (e.g., made by an aluminum die cast process, each having generally a flat trapezoidal configuration with a base portion having a cross-section similar to that of chassis 12, fit to the open top and bottom ends of chassis 12 so as to be releasably secured thereto by such as screws. Introduced into the central rectangular opening 13a formed in each of frames 13 in their inner vertical wall is a fan 5 which is mounted on a mounting board to be secured thereto. Elements 6 constituting the other electrical circuit are mounted to chassis 12 on the front surface of the side to which fins 4 are mounted, and an openable and closeable panel 8 which is hinged to the right hand posts projected forwards from upper and lower frames 13, respectively, by hinges 7, panel 8 mounting a printed circuit board 9 thereon through insulating spacers 10. On the basis of circuit diagrams the various components described above are appropriately wired together.

Upon operation of the inverter apparatus, semiconductor elements 3 of the main electrical circuit generate heat to be conducted to radiating fins 4, raising their temperatures, but due to the passage of air by fans 5 for ventilation the temperatures of fins 4 are lowered so that the normal characteristics of main electrical circuit components 3 are maintained. In this case, the ventilating air flows passes through a wind channel A (see Fig. 6) constituted by upper and lower frames 13 as well as the sides of rectangular chassis 12, so no heated air impinges upon the other components. Due to the fact that radiating fins 4 which hold amost all of the generated heat are mounted in wind channel A and are shielded apart from the other components, even if ducts 15 are connected to the flange portions of upper and lower frames 13 so that the outside air is passed through ducts 15 to ventilate wind channel A, the ventilating air impinges only upon fins 4 within wind channel A, without impinging upon other electrical components, whereby no thermal effects can be imparted upon them. In a case where the control apparatus is to be used in adverse environments such as those where there is a suspended oil mist or where there is much dust, etc the air flows only within wind channel A, making it possible to cool only radiating fins 5, and to allow the electrical components of the other control circuits and the main electrical circuit to be operated without being struck by the dirty air outside chassis 12 so that an inverter apparatus having a long life and high reliability can be realized.

From the foregoing it will be appreciated that since chassis 12 in accordance with the present invention is comprised of sheet metal members constituting its sides and cast members constituting upper and lower frames 13 detachably secured to the sheet metal members to form the upper and lower ends of chassis 12, even if it is necessary to make chassis 12 larger according to the capacity of the inverter apparatus, it can be easily adapted by merely forming the sides constituted from sheet metal into greater dimensions in height without changing the cross sectional shape and dimensions of chassis 12 and with cast frames 13 which constitute the upper and lower ends of chassis 12 being commonly utilized for any capacity inverter apparatus.

Thus, the present invention can contribute to the standardization of production of inverter apparatuses.

In addition the constitution of the upper and lower ends of chassis 12 from cast frames 13 is aimed at strengthening chassis 12 and also facilitates the mounting of cooling fans 5.

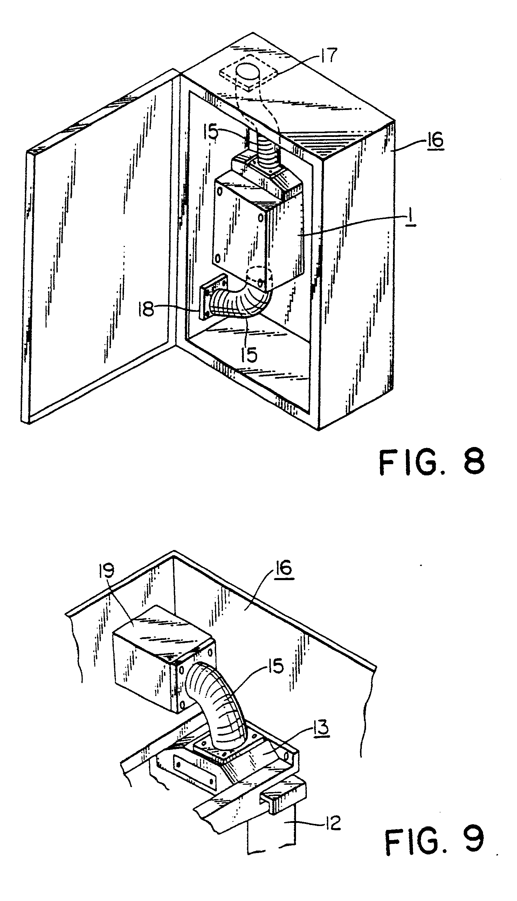

Fig. 8 is an embodiment that indicates the state of mounting of the inverter apparatus to a control housing 16 wherein the reference numeral 15 shows flexible pipes which are respectively connected between the wind channel of the inverter apparatus 1 and the suction part 18 and discharge port 17 formed in control housing 16. The other members are identical to those in the prior art.

Fig. 9 shows a further embodiment of the present invention wherein is shown a flexible pipe 15 and a duct connecting member 19 having a hollow square cross-section as connected between the wind channel of the body 1 of an inverter apparatus and the suction or discharge port of the control housing 16. There are two methods of connecting the flange portion of the chassis 12 of inverter apparatus 1 with the suction or discharge port of the control housing 16, i.e. the orthogonally up and down direction and the rear side horizontal direction in which the direction is diverted at 90° by connecting flexible pipe 15. Therefore, there are four combinations when the connections at the upper and lower parts are considered.

In this embodiment, as described above, since flexible pipe 15 is used to connect the wind channel of chassis 12 of inverter apparatus 11 to the suction or discharge port of control housing 16 there is flexibility in the relationship between their mounting positions, without the need of preparing connecting pipes having various shapes which are appropriate in order in meeting the particular mounting state of the inverter apparatus as has been hitherto usual, so the design and the production become easier and standardization of production can be realized.

Although the present invention has been explained and indicated above as being embodied for inverter apparatus, it should be noted that the present invention can also be similarly applicable to control apparatuses in which there are large amounts of heat generated by semiconductor elements such as transistors, thyristors, etc.

It is to be understood that although certain forms of the present invention have been illustrated and described, it is not to be limited thereto except insofar as such limitations are included in the following claims.

## Claims

1. A power electronic control apparatus comprising a chassis (12) which defines a cooling air duct, ventilating means (5) for passing air through the duct, and at least one circuit component (3) mounted on a side wall of the chassis through an opening formed in the side wall, characterised in that the chassis (12) has its side walls formed of sheet metal, and upper and lower ends consisting of cast frames (13) of standardised dimensions with air-flow apertures, and the ventilating means (5) is mounted in an aperture in at least one of the said cast frames (13) so as to pass cooling air through the air duct formed by the cast end frames and the sheet metal sides, the cast end frames being attached to the sheet metal sides.

2. A control apparatus as claimed in claim 1 further comprising a control housing to receive therein said chassis, characterised by flexible pipes (15) connecting the suction and discharge ports opened at predetermined portions in said upper and lower ends of said control chassis with the suction and discharge ports formed at predetermined portions of said housing.

3. A control apparatus as claimed in claim 1 or 2 characterised in that a panel (8) is provided between the upper and lower cast frames (13) so as to be opened and closed about one side by means of hinges arranged above and below, and a printed circuit board (9) is carried on said panel (8) through insulating supports (10).

4. A control apparatus according to claim 1, 2 or 3 characterised in that the chassis (12) has a rectangular tubular shape formed by bending metal sheet plate;

radiating fins (4) are mounted on one of the sides of said chassis (12) so as to protrude within said chassis through an opening formed therein;

said circuit members are semiconductor means (3) secured to said radiating fins (4);

and said cooling fans (5) are mounted within central rectangular openings formed in the cast frames (13) respectively.

## Patentansprüche

1. Leistungselektronisches Steuergerät mit einem Chassis (12), das einen Kühlluftkanal begrenzt, Lüftungsmitteln (5), die Luft durch den Kanal leiten, und mindestens einem Schaltungselement (3), das an einer Seitenwand des Chassis durch eine in der Seitenwand gebildete Öffnung befestigt ist, dadurch gekennzeichnet, daß die Seitenwände des Chassis (12) aus Metallblech bestehen und das Chassis (12) ein oberes und ein unteres Ende aufweist, die aus gegossenen Rahmen (13) mit Standardabmessungen und Luftströmungsöffnungen bestehen, und daß die Lüftungsmittel (5) in einer Öffnung in mindestens einem der gegossenen Rahmen (13) so befestigt sind, daß Kühlluft durch den Luftkanal geleitet wird, der durch die gegossenen Endrahmen und die Metallblechseitenwände gebildet wird, wobei die gegossennen Endrahmen an den Metallblechseitenwänden befestigt sind.

2. Steuergerät nach Anspruch 1, das ferner ein Steuergehäuse zur Aufnahme des Chassis aufweist, gekennzeichnet durch biegsame Rohrleitungen (15), die die in vorbestimmten Abschnitten im oberen und im unteren Ende des Steuerchassis sich öffnenden Ansaug- und Austrittsöffnungen mit den in vorbestimmten Abschnitten des Gehäuses gebildeten Ansaug- und Austrittssöffnungen verbinden.

3. Steuergerät nach Anspruch 1 oder 2, dadurch gekennzeichnet, daß zwischen dem oberen und dem unteren gegossenen Rahmen (13) eine Platte (8) vorgesehen ist, die mittels unten und oben angeordneter Scharniere um eine Seite zu öffnen und zu schließen ist, und daß die Platte (8) eine Leiterplatte (9) über Isolierhalterungen (10) trägt.

4. Steuergerät nach Anspruch 1, 2, oder 3, dadurch gekennzeichnet, daß das Chassis (12) eine durch Biegen von Metallblech gebildete Viereckrohrform hat;

daß Abstrahlungsrippen (4) auf einer Seite des Chassis (12) so befestigt sind, daß sie durch eine im Chassis gebildete Öffnung in dieses vorstehen;

daß die Schaltungselemente an den Abstrahlungsrippen (4) befestigte Halbleiterelemente (3) sind;

und daß die Kühlgebläse (5) jeweils in in den gegossenen Rahmen (13) gebildeten mittigen Vierecköffnungen befestigt sind.

## Revendications

1. Appareil de contrôle électronique de puissance comprenant un châssis (12) qui définit une gaine d'air de refroidissement, un moyen de ventilation (5) pour faire passer de l'air à travers la gaine et au moins un composant de circuit (3) monté sur une paroi latérale du châssis à travers une ouverture formée dans la paroi latérale, caractérisé en ce que le châssis (12) a ses parois latérales formées en tôle et des extrémités supérieure et inférieure consistant en encadrements coulés (13) de dimensions standardisées avec ouvertures d'écoulement d'air, et le moyen de ventilation (5) est monté dans une ouverture dans au moins l'un desdits encadrements coulés (13) de façon à faire passer l'air de refroidissement à travers la gaine d'air formée par les encadrements extrêmes coulés et les côtés en tôle, les encadrements extrêmes coulés étant attachés aux côtés en tôle.

2. Appareil de contrôle selon la revendication 1 comprenant de plus un boîtier de contrôle pour recevoir ledit chässis, caractérisé par des tubes flexibles (15) reliant les orifices d'aspiration et de refoulement ouverts en des parties prédéterminées dans lesdites extrémités supérieure et inférieure dudit châssis de contrôle avec les orifices d'aspiration et de refoulement formés en des parties prédéterminées dudit boîtier.

3. Appareil de contrôle selon la revendication 1 ou 2 caractérisé en ce qu'un panneau (8) est prévu entre les encadrements coulés supérieur et inférieur (13) afin d'être ouvert et fermé autour d'un côté au moyen de charnières angencées au-dessus et en dessous, et une planche de circuit imprimé (9) est portée sur ledit panneau (8) par l'intermédiaire de supports isolants (10).

4. Appareil de contrôle selon la revendication 1, 2 ou 3 caractérisé en ce que le châssis (12) a une forme tubulaire rectangulaire formée en cintrant une plaque en tôle;

des ailettes rayonnantes (4) sont montées sur l'un des côtés châssis (12) afin de dépasser dans ledit châssis à travers une ouvertures qui y est formée;

lesdits éléments de circuit sont des moyens semiconducteurs (3) qui sont fixés auxdites ailettes rayonnantes (4);

et lesdits ventilateurs de refroidissement (5) sont montés dans des ouvertures centrales rectangulaires formée dans les encadrements coulés (13) respectivement.

FIG. I

PRIOR ART

FIG. 3

PRIOR ART

FIG. 2

PRIOR ART

# FIG. 4

# FIG. 6

# FIG. 5

# FIG. 7

FIG. 8

FIG. 9